# EUROPÄISCHE PATENTANMELDUNG

(11) **EP 1 536 564 A1**
(43) Veröffentlichungstag der Anmeldung: **01.06.2005**
(21) Anmeldenummer: 04023119.3
(22) Anmeldetag: 29.09.2004
(51) Int. Cl.: H03K 17/16

(54) **Verfahren zur Ansteuerung eines Bipolartransistors mit isolierter Gate-Elektrode und Vorrichtung zur Durchführung des Verfahrens**

(30) Priorität: 26.11.2003 DE 10355255
(71) Anmelder: Rexroth Indramat GmbH, 97816 Lohr am Main (DE)
(72) Erfinder: Siegler, Ralf, 97816 Lohr am Main (DE); Braun, Georg, 97816 Lohr am Main (DE); Bund, Gerhard, 97816 Lohr am Main (DE)
(74) Vertreter: Thürer, Andreas

(57) **Zusammenfassung**

Verfahren zur Ansteuerung eines Bipolartransistors mit isoliert angeordneter Gate-Elektrode (IGBT) mittels eines Gate-Treibers (3), um bei unveränderten Schaltzeiten eine Reduzierung der Totzeiten bzw. Verbesserung der Regelgüte bei möglichst geringen Schaltverlusten zu erreichen, wobei zur Abschaltregelung, insbesondere zur Entladung der Gate-Kapazität, die Kollektor-Emitter-Spannung von einer Überwachungseinrichtung (2) überwacht wird, wobei nach Maßgabe einer Überwachungsvorschrift der Abschaltvorgang über eine erste und/oder eine zweite Abschaltvorrichtung (1) bewirkt wird und beide Abschaltvorrichtungen (1) unterschiedliche Entladecharakteristika aufweisen.

Die Vorrichtung zur Durchführung des Verfahrens weist als Bestandteil der Abschaltregelung eine in die Gate-Ansteuerung eingebundene Entladeschaltung (1) auf, welche mittels eines ersten Zweiges eine niederohmige Entladung der Gate-Kapazität bewirkt und mittels eines zweiten Zweiges eine Entladung mittels eines Steuerstromes bewirkt, wobei die Zweige nach Maßgabe des Kollektor-Emitter-Spannungs-Verlaufes aktivierbar bzw. deaktivierbar sind.

## Beschreibung

Die Erfindung entspringt aus dem Gebiet der Leistungselektronik und beschreibt ein Verfahren bzw. eine Vorrichtung zur Ansteuerung eines Bipolartransistors mit isoliert angeordneter Gate-Elektrode (IGBT) gemäß den Oberbegriffen der unabhängigen Ansprüche.

IGBTs werden vorzugsweise dann eingesetzt, wenn hohe Ströme geschaltet werden müssen. Dies ist insbesondere in der Antriebstechnik der Fall, wo der Antriebsregler mittels einer Leistungsendstufe über eine IGBT-Brückenschaltung zum Beispiel die drei Phasen eines AC-Motors mit Strom versorgt. Das Gate eines jeden IGBTs wird dabei über Impulse angesteuert, die von einem PWM-Modulator stammen. Diese Gate-Ansteuerung übernimmt in der Regel ein sogenannter Gate-Treiber, dessen charakteristische Daten einen wesentlichen Einfluss auf die Ausgangssignale der Leistungsendstufe haben, insbesondere auf Flankensteilheit und Verluste im Betrieb.

Die Offenlegungsschrift DE 196 10 895 A1 zeigt ein Verfahren zur Einschaltregelung eines IGBTs und eine Vorrichtung zur Durchführung dieses Verfahrens. Die Beschreibung offenbart die Ansteuerung zum Einschalten des IGBT-Gates mittels einer Stromquelle anstelle der sonst üblichen Steuerspannung. Man nutzt hierbei die Erkenntnis, dass zwischen Gatespannung und Laststrom ein quadratischer Zusammenhang besteht, sobald die Gatespannung größer als die Thresholdspannung ist und kann damit unabhängig von einer lastseitigen Messeinrichtung den Laststrom beeinflussen.

Diese Schrift wird für die vorliegende Anmeldung als nächstkommender Stand der Technik betrachtet.

Das Ausschalten eines IGBTs beispielsweise durch eine negative Gatespannung bewirkt jedoch abhängig von der Ansteuergeschwindigkeit ein mehr oder weniger großes lastseitiges di/dt. Erhöht man die Ansteuergeschwindigkeit zum Ein- bzw. Ausschalten des IGBTs, so führt dies zwar zu einer schnelleren Umschaltung zwischen leitendem und nicht leitendem Zustand des IGBTs, gleichzeitig kann dies aber auch aufgrund der stark induktiven Lasten, wie Motorwicklungen und Zuleitungen, wegen des erhöhten di/dt zu Überspannungen führen, welche die zulässigen Höchstwerte der verwendeten Bauteile und Komponenten überschreiten und damit zur Zerstörung oder Beschädigung von Schaltung und Peripherie führen können. Verlangsamt man dagegen den Schaltvorgang, so verringert sich dadurch zwar der Wert di/dt, zusätzlich erhöhen sich damit aber auch die Totzeiten im gesamten Regelkreis eines beispielsweise Antriebsreglers, in den eine erfindungsgemäße IGBT-Brückenschaltung eingebunden sein könnte. Erhöhte Totzeiten führen zu einer Verschlechterung der Regelgüte und diese wiederum dazu, dass evtl. Anforderungen eines zu regelnden Systems nicht mehr eingehalten werden können.

Diese Problematik wird in der zitierten Schrift weder betrachtet noch gelöst. Aufgabe der Erfindung ist es, ein Verfahren bzw, eine Vorrichtung anzugeben, um bei unveränderten Schaltzeiten eine Reduzierung der Totzeiten bzw. Verbesserung der Regelgüte bei möglichst geringen Schaltverlusten zu erreichen. Diese Aufgabe wird durch die Merkmale der unabhängigen Ansprüche gelöst. Weitere vorteilhafte Ausgestaltungen der Erfindung ergeben sich aus den Unteransprüchen.

Beim erfindungsgemäßen Verfahren wird zur Abschaltregelung, insbesondere zur Entladung der Gate.-Kapazität, die Kollektor-Emitter-Spannung von einer Überwachungseinrichtung überwacht, wobei nach Maßgabe einer Überwachungsvorschrift der Abschaltvorgang über eine erste und/oder eine zweite Abschaltvorrichtung bewirkt wird und beide Abschaltvorrichtungen unterschiedliche Entladecharakteristika aufweisen. Durch einen beeinflussbaren Abtransport der mittels der Gate-Kapazität gespeicherten Ladungsträger wird mittels der unterschiedlichen Entladecharakteristika beider zu- bzw. abschaltbaren Abschaltvorrichtungen der Abschaltvorgang eines IGBTs steuerbar.

So wäre es beispielsweise denkbar, den größten Anteil der Ladungsträger über die erste Abschaltvorrichtung zu beseitigen und damit eine möglichst rasche Entladung der Gate-Kapazität zu gewährleisten und gezielt über die zusätzliche Abschaltvorrichtung weitere Ladungsträger abzuführen. Mittels dieser gezielten Entladung ließe sich der Abschaltvorgang dann so gestalten, dass durch geeignete Dimensionierung der verwendeten Komponenten die Anforderungen bzgl. maximal zulässiger Spannungen und Ströme an über die IGBTs versorgte Peripherie eingehalten werden können. Dies könnte beispielsweise die Spannungsfestigkeit einer Motorwicklung oder einer Zuleitung zur leistungsmäßigen Versorgung einer elektrischen Maschine sein.

Verfährt man so, dass zunächst beide Abschaltvorrichtungen aktiv sind und anschließend eine der beiden Abschaltvorrichtungen gemäß der Überwachungsvorschrift deaktiviert wird, dann könnten Ladungsträger entsprechend der unterschiedlichen Entladecharakteristika abgeführt werden. Eine feinere Ausregelung wäre damit möglich, so dass sich auch Einschwingvorgänge der Abschaltvorrichtungen weniger auf das Abschaltverhalten auswirken.

Verfährt man so, dass die Abschaltvorrichtungen gemäß der Überwachungsvorschrift alternierend aktiv sind, werden die Ladungsträger der Gate-Kapazität ebenfalls systematisch abgeführt. Besonderer Vorteil hierbei ist jedoch, dass abhängig von der Ansteuerphase eine gezielte Wahl zwischen unterschiedlichen Entladecharakteristika möglich ist; während in den vorherigen Fällen zunächst beide Entladecharakteristika ihre Wirkungen entfalten.

Bildet man die Überwachungseinrichtung für die Kollektor-Emitter-Spannung so aus, dass die Überwachungsvorschrift änderbar ist und insbesondere die Überwachung von Potentialänderungen vorschreibt, so können die Umschaltzeitpunkte abhängig vom Verhalten der Kollektor-Emitter-Spannung definiert werden. Denkbar wäre auch eine schwellwertabhängige Schaltung abhängig vom Absolutwert der Kollektor-Emitter-Spannung.

Besonders vorteilhafte Auswirkungen hat die Erfindung, wenn die erste Abschaltvorrichtung eine niederohmige und die zweite Abschaltvorrichtung eine stromgesteuerte Entladecharakteristik aufweist. Damit kann einerseits eine sehr rasche Abführung von Ladungsträgern aus der Gate-Kapazität, aber auch eine steuerbare Abführung realisiert werden.

Bildet man eine Abschaltvorrichtung so aus, dass das Verhalten der Abschaltvorrichtungen in Bezug auf ihre Einschaltzeiten und/oder bezüglich ihres Ladungsträgerdurchsatzes konfigurierbar ist, kann damit eine peripherieabhängige Entladekurve leicht realisiert bzw. nachgebildet werden.

Große Vorteile hat das Verfahren, wenn die Abschaltvorrichtungen, insbesondere auch bei einem lastseitigen Fehler, beispielsweise bei einem Kurzschluss, ansprechen. Gerade hierbei können sehr hohe Ströme auftreten, die zur Zerstörung oder Schädigung von angeschlossenen Komponenten führen würden. Es kann somit einer Überbeanspruchung der Komponenten aufgrund eines überhöhten Stromes vorgebeugt werden, indem eine schnellstmögliche Abschaltung erfolgt, die zusätzlich auch unzulässige Spannungsspitzen vermeidet.

Die Vorrichtung zur Durchführung des Verfahrens zeichnet sich dadurch aus, dass Bestandteil der Abschaltregelung, insbesondere während der Entladung der Gate-Kapazität, eine in die Gate-Ansteuerung eingebundene Entladeschaltung ist, welche mittels eines ersten Zweiges eine niederohmige Entladung der Gate-Kapazität bewirkt und mittels eines zweiten Zweiges eine Entladung mittels eines Steuerstromes bewirkt, wobei die Zweige nach Maßgabe des Kollektor-Emitter-Spannungs-Verlaufes aktiviert bzw. deaktiviert sind.

Die bereits genannten Vorteile lassen sich auch dadurch erreichen, dass zunächst beide Zweige aktiv sind und einer der beiden Zweige nach Maßgabe des Kollektor-Emitter-Spannungs-Verlaufes abgeschaltet wird oder beide Zweige nach Maßgabe des Kollektor-Emitter-Spannungs-Verlaufes alternierend aktiv sind.

Reagiert man bei Auswertung des Kollektor-Emitter-Spannungs-Verlaufes auf die Spannungsänderungen anstelle von Spannungspegeln, kann relativ exakt der Zeitpunkt erfasst werden, zu dem die Kollektor-Emitter-Spannung einen mehr oder weniger stabilen Zustand erreicht hat. Man wird damit unabhängig von den Absolutwerten. Wählt man trotzdem eine Schwellwerterkennung und wäre der von der Schwellwerterkennung überwachte Schwellwert der Kollektor-Emitter-Spannung zusätzlich noch einstellbar, könnten abhängig von der Applikation einfach und schnell Adaptierungen vorgenommen und auf den Umschaltzeitpunkt zwischen beiden Zweigen könnte leicht Einfluss genommen werden.

Ist die Vorrichtung vorteilhafterweise so ausgebildet, dass der erste Zweig eine Ein/Aus-Funktion mit minimalem Innenwiderstand realisiert und der zweite Zweig eine konstante Ladungsträgerabfuhr gewährleistet, kann man zunächst schnell und effektiv die größte Anzahl der Ladungsträger von der Gate-Kapazität absaugen, bevor eine gezielte stromgesteuerte Abfuhr erfolgt.

Baut man den ersten Zweig aus einem als Schalter ausgelegten Transistor und den zweiten Zweig aus einem als Konstantstromquelle beschalteten Transistor, so ist eine preiswerte Realisierung der erfindungsgemäßen Lösung mittels dem Fachmann bekannter Standardschaltungen und Standardkomponenten möglich.

Steuert man die Zeitdauer, während der die Zweige aktiviert bzw. deaktiviert sind, mittels einer Zeitsteuerung, so ergeben sich noch mehr Freiheitsgrade bei der Anpassung an die Peripherie. Eine preiswerte Zeitsteuerung wäre dadurch gekennzeichnet, dass die Beeinflussung der Zeitdauer über die Zeitkonstante eines RC-Gliedes erfolgt. Zur Beeinflussung der Zeitkonstanten wäre die Verwendung variabler Widerstände und/oder Kondensatoren mit passend gewählten Toleranzen und ggf. Kompensationsschaltungen zu empfehlen. Auch integrierte Schaltkreise oder eine softwaremäßige Ansteuerung sind selbstverständlich denkbar.

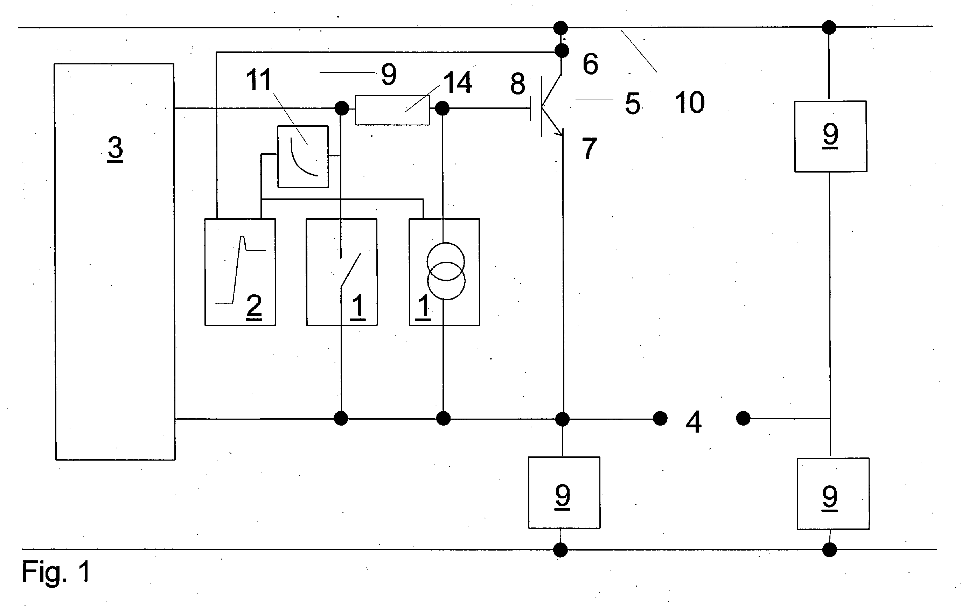

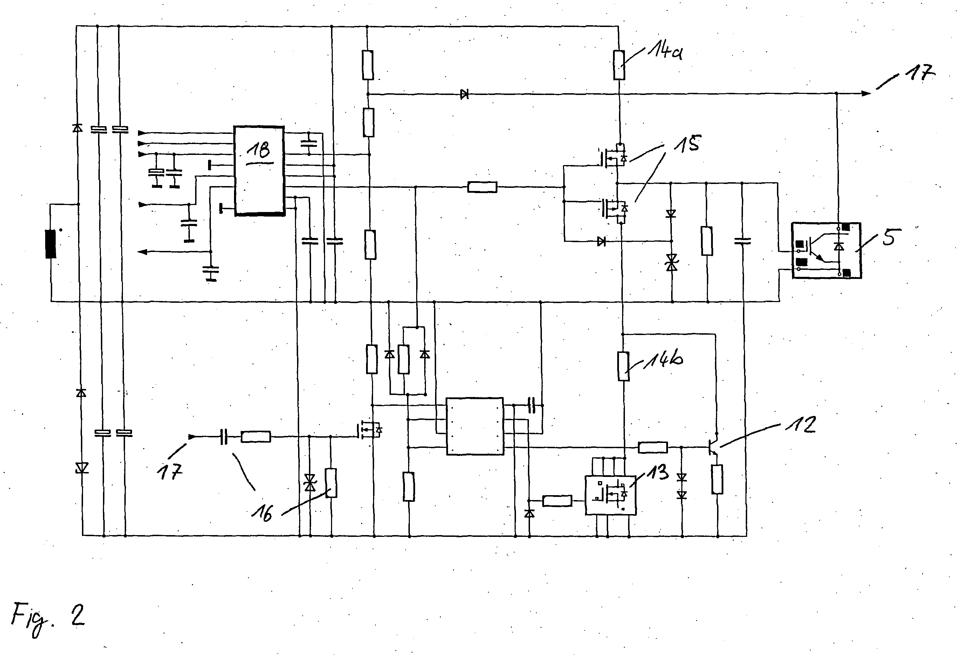

Nachfolgend wird die Erfindung skizzenhaft erläutert. Es zeigt Figur 1 grob schematisch eine Ausführungsform einer Vorrichtung zur Ansteuerung eines Bipolartransistors mit isoliert angeordneter Gate-Elektrode mittels eines Gate-Treibers. Es ist nur ein IGBT einer komplementären IGBT-Leistungsendstufe innerhalb einer Brückenschaltung dargestellt. Figur 2 zeigt eine Ausführungsform einer Gate-Ansteuerung zur Entladung der Gate-Kapazität als etwas detaillierteres Prinzipschaltbild.

Die in der Zeichnung verwendeten Bezugszeichen und deren Bedeutung sind in der Bezugszeichenliste zusammengefasst. Gleiche Teile in den Figuren tragen grundsätzlich gleiche Bezugszeichen.

Figur 1 zeigt eine Brückenschaltung von IGBTs mit der erfindungsgemäßen Ausführungsform der Ansteuervorrichtung 9 zur Durchführung des oben beschriebenen Verfahrens. Diese Ansteuervorrichtung 9 beinhaltet folgende Komponenten: Die Abschaltvorrichtungen 1, die Schwellwert-Überwachungseinrichtung 2, den lastseitigen Anschluss 4 für eine über den Zwischenkreisbus 10 gespeiste Last sowie einen IGBT 5 mit Kollektor 6, Emitter 7, Gate-Elektrode 8, Gate-Treiber 3, Zeitglied 11 und den Gate-Widerstand 19. Beim Abschalten wird die Gatespannung reduziert und beide Abschaltvorrichtungen 1 aktiv geschaltet. In diesem Falle sind die Abschaltvorrichtungen als einfacher Schalter bzw. als Stromquelle realisiert. Selbstverständlich sind auch komplexere Realisierungsformen denkbar.

Bei Reduzierung der Gatespannung durch den Gate-Treiber 3 sinkt durch Abführen der Gateladung die Gatespannung zunächst bis zu einem bestimmten Wert und verharrt dort (Plateauphase). Es werden Ladungsträger durch beide Abschaltvorrichtungen 1 abgeführt und zwar zunächst durch beide gleichzeitig. Dies hat den Vorteil, dass eine maximal mögliche Ladungsträgermenge gleich zu Beginn abgesaugt werden kann und trotzdem die elektronischen Schaltkreise der Abschaltvorrichtungen, insbesondere die Stromquelle, genügend Zeit zum Einschwingen haben.

Wegen der großen Menge von Ladungsträgern steigt 'die Kollektor-Emitter-Spannung anfangs nur langsam an, denn die zwischen Kollektor und Gate wirkende Millerkapazität besitzt einen relativ großen Wert. Mit der sinkenden Anzahl von beweglichen Ladungsträgern steigt die Kollektor-Emitter-Spannung dann schneller an. Dies ist ein Zeichen dafür, dass ein großer Prozentsatz der Ladungsträger abgesaugt wurde.

Dieser Anstieg wird mittels der Spannungs-Überwachungseinrichtung 2 erfasst, entweder wie schon beschrieben direkt (Absolutwertmessung) oder indirekt (Deltamessung, d.h. Erfassung von Änderungen der Kollektor-Emitter-Spannung). Erkennt die Spannungs-Überwachungseinrichtung 2 im Falle einer Deltamessung, dass sich die Kollektor-Emitter-Spannung nicht mehr ändert, d.h. sich stabilisiert hat, so schaltet sie die als Schalter konzipierte Abschaltvorrichtung 1 zunächst ab und es ist nur noch die Stromquelle aktiv, damit die restlichen Ladungsträger kontrolliert abgesaugt werden. Sobald die Gatespannung unter ihre Schwellspannung sinkt, sperrt der MOS-Transistor im IGBT. Spannungsspitzen beim Ausschalten können durch kaum vermeidbare Streuinduktivitäten im Laststrompfad entstehen.

Mittels der Erfindung wird die zu Beginn erwähnte Plateauphase, während dieser viele Ladungsträger abzuführen sind, verkürzt und das Schaltverhalten des IGBT beschleunigt. Totzeiten bei der Stromregelung, beispielsweise mittels eines Antriebsreglers, verringern sich.

Die noch aktive Stromquelle der zweiten Abschaltvorrichtung 1 sorgt für eine mehr oder weniger geregelte Abfuhr von Ladungsträgern während die als Schalter ausgeführte zweite Abschaltvorrichtung 1 zunächst keine Regelung während des Ladungsträgerabflusses zulässt. Üblicherweise wird man zur Realisierung der Abschaltvorrichtungen 1 Transistoren mit entsprechender Beschaltung wählen, es ist aber auch der Einsatz von integrierten Schaltungen möglich, die ggf. mehr Komfort und Freiheit bzgl. Dimensionierung ihrer charakteristischen Eigenschaften bieten.

Um das Schaltverhalten der als Schalter ausgelegten Ansteuervorrichtungen 1 zu koordinieren, wird mittels einer Zeitsteuerung, beispielsweise eines RC-Gliedes, die Einschaltdauer während der Abschaltung des IGBTs festgelegt. Über komplexere Schaltkreise wären hier weitaus komfortablere Gestaltungsmöglichkeiten oder ein programmierbares Verhalten denkbar.

Das Einschalten des IGBT erfolgt wiederum durch Anlegen einer positiven Spannung an das Gate. Ein gebräuchlicher Spannungswert liegt bei +15V.

Nach erneutem Einschalten folgt wieder das Abschalten des IGBTs und der Vorgang beginnt erneut - wie schon beschrieben - abzulaufen. Es handelt sich also um einen periodischen Vorgang, der für den Normalbetrieb des IGBTs (z.B. Bestromung eines Motors mittels einer als Brückenschaltung über die Leistungsendstufe eines Antriebsreglers) relevant ist.

Im Fehlerfalle kann die Schaltung einen zuverlässigen Schutz der Peripherie und der Bauteile vor einem hohen du/dt bzw. di/dt bieten, insbesondere bei induktiven Verbrauchern. Weiterhin werden Störeinkopplungen vermindert, Überspannungen an der Motorwicklung reduziert und Erdableitströme verringert.

Figur 2 zeigt folgende Komponenten: Die Gate-Widerstände 14 a/b, den als niederohmigen Schalter fungierenden Transistor 13, den als Stromquelle beschalteten Transistor 12, die Ausgangsstufe 15 des Gate-Treibers, das RC-Glied 16, den angesteuerten IGBT 5, einen Optokoppler 18, die Rückführung 17 sowie zahlreiche Bauteile als externe Beschaltung der ICs zur Herstellung von Arbeitspunkten und zur Konfiguration gemäß der Datenblätter.

Der Optokoppler dient als Schnittstelle zwischen Steuerlogik und Leistungsteil bei der Ansteuerung der Gate-Treiber-Ausgangsstufe 15 über PWM-Signale. Um den IGBT 5 einzuschalten, wird der obere MOSFET der Gate-Treiber-Ausgangsstufe 15 leitend geschaltet, so dass über den Gate-Widerstand 14a die Gate-Kapazität des IGBTs geladen werden kann, bis der IGBT einen Strom aus dem angeschlossenen Zwischenkreisbus, zum Beispiel bei Verwendung als Endstufe für einen Antriebsregler, zieht. Dieser Vorgang soll allerdings hier nicht weiter beleuchtet werden, da sich die Erfindung schwerpunktmäßig mit dem Abschaltvorgang beschäftigt. Zu erwähnen ist aber, dass während des Einschaltvorganges die im Anschluss erläuterte Stromquelle 12 und der Schalter 13 nicht aktiv sind. Der untere Transistor der Gate-Treiber-Ausgangsstufe 15 wird leitend, sobald die Stufe mit einer negativen Spannung angesteuert wird, was dann bewirkt, dass das Gate des IGBT 5 über den Gate-Widerstand 14b und den Schalter 13 bzw. über die Stromquelle 12 entladen werden kann. Bei Schalter 13 handelt es sich in diesem Falle um einen MOSFET, der spannungsgesteuert leitet oder sperrt.

Bei Ansteuerung der Gate-Treiber-Ausgangsstufe 15 mit einer negativen Spannung bewirkt die vorhandene Schaltung, dass der Schalter 13 und die Stromquelle 12 zunächst gleichzeitig aktiviert werden. Gleichzeitig haben beide Vorrichtungen genügend Zeit ihre Arbeitspunkte zu stabilisieren und einzuschwingen.

Ab dem Startzeitpunkt der Entladung der Gate-Kapazität wird sich die Kollektor-Emitter-Spannung kontinuierlich verändern. Dies ist bereits weiter oben bei Figur 1 beschrieben. Diese Veränderung wird über die Rückkopplung 17 erfasst und das hieraus resultierende Signal speist das RC-Glied 16. Bei der Dimensionierung des RC-Gliedes ist zu beachten, dass ein Kondensator hoher Spannungsfestigkeit verwendet wird (hier 3000 V). Typische Werte der rückgekoppelten du/dt liegen bei 4.5 kV/usec. Abhängig von der Zeitkonstanten der verwendeten RC-Kombination, die empirisch im Versuch ermittelt wurde, ist die Aktivität des Schalters 13 zeitlich limitiert und direkt von einer Änderung (du/dt) der Kollektor-Emitter-Spannung abhängig. Sobald diese Spannung konstant bleibt, schaltet der Schalter 13 ab und es ist nur noch die Stromquelle 12 aktiv, was zu einer gezielten Abfuhr der restlichen Ladungsträger aus der Gate-Kapazität führt. Wenn ein neuer Einschaltimpuls durch den Optokoppler 18 folgt, schaltet auch die Stromquelle 12 ab und die Gate-Kapazität wird wieder geladen. Der geschilderte Vorgang beginnt dann von Neuem.

### Bezugszeichenliste

- 1: Abschaltvorrichtung
- 2: Überwachungseinrichtung
- 3: Gate-Treiberstufe
- 4: Lastseitiger Anschluss
- 5: IGBT
- 6: Kollektor
- 7: Emitter
- 8: Gate
- 9: Ansteuervorrichtung
- 10: Zwischenkreisbus
- 11: Zeitglied
- 12: Stromquelle
- 13: Niederohmige Abschaltvorrichtung
- 14: Gate-Widerstand
- 15: Gate-Treiber-Ausgangsstufe
- 16: RC-Glied
- 17: Dynamische Rückkopplung für die Kollektor-Emitter-Spannung
- 18: Optokoppler

## Patentansprüche

1. Verfahren zur Ansteuerung eines Bipolartransistors mit isoliert angeordneter Gate-Elektrode (IGBT) mittels eines Gate-Treibers (3), **dadurch gekennzeichnet, dass** zur Abschaltregelung, insbesondere zur Entladung der Gate-Kapazität, die Kollektor-Emitter-Spannung von einer Überwachungseinrichtung (2) überwacht wird, wobei nach Maßgabe einer Überwachungsvorschrift der Abschaltvorgang über eine erste und/oder eine zweite Abschaltvorrichtung (1) bewirkt wird und beide Abschaltvorrichtungen (1) unterschiedliche Entladecharakteristika aufweisen.

2. Verfahren nach Anspruch 1, **dadurch gekennzeichnet, dass** zunächst beide Abschaltvorrichtungen (1) aktiv sind und anschließend eine der beiden Abschaltvorrichtungen (1) gemäß der Überwachungsvorschrift deaktiviert wird.

3. Verfahren nach Anspruch 1, **dadurch gekennzeichnet, dass** die Abschaltvorrichtungen (1) gemäß der Überwachungsvorschrift alternierend aktiv sind.

4. Verfahren nach einem der vorherigen Ansprüche, **dadurch gekennzeichnet, dass** die Überwachungsvorschrift änderbar ist und insbesondere die Überwachung von Potentialänderungen vorschreibt.

5. Verfahren nach einem der vorherigen Ansprüche, **dadurch gekennzeichnet, dass** die erste Abschaltvorrichtung (1) eine niederohmige und die zweite Abschaltvorrichtung (1) eine stromgesteuerte Entladung der Gate-Kapazität bewirkt.

6. Verfahren nach einem der vorherigen Ansprüche, **dadurch gekennzeichnet, dass** das Verhalten der Abschaltvorrichtungen (1) in Bezug auf ihre Einschaltzeiten und/oder bezüglich ihres Ladungsträgerdurchsatzes konfigurierbar ist.

7. Verfahren nach einem der vorherigen Ansprüche, **dadurch gekennzeichnet, dass** die Abschaltvorrichtungen (1), insbesondere auch bei einem lastseitigen Fehler, beispielsweise bei einem Kurzschluss, ansprechen.

8. Vorrichtung zur Durchführung des Verfahrens nach 1 bis 7 zur Ansteuerung eines Bipolartransistors mit isoliert angeordneter Gateelektrode (IGBT) mittels eines Gate-Treibers (3) , **dadurch gekennzeichnet, dass**
Bestandteil der Abschaltregelung, insbesondere während der Entladung der Gate-Kapazität, eine in die Gate-Ansteuerung eingebundene Entladeschaltung ist, welche mittels eines ersten Zweiges (1) eine niederohmige Entladung der Gate-Kapazität bewirkt und mittels eines zweiten Zweiges (1) eine Entladung mittels eines Steuerstromes bewirkt, wobei die Zweige (1) nach Maßgabe des Kollektor-Emitter-Spannungs-Verlaufes aktiviert bzw. deaktiviert sind.

9. Vorrichtung nach Anspruch 8, **dadurch gekennzeichnet, dass** nach Maßgabe des Kollektor-Emitter-Spannungs-Verlaufes zunächst beide Zweige (1) aktiv sind und einer der beiden Zweige nach Maßgabe des Kollektor-Emitter-Spannungs-Verlaufes abgeschaltet wird.

10. Vorrichtung nach Anspruch 8, **dadurch gekennzeichnet, dass** beide Zweige (1) nach Maßgabe des Kollektor-Emitter-Spannungs-Verlaufes alternierend aktiv sind.

11. Vorrichtung nach einem der Ansprüche 8 bis 10, **dadurch gekennzeichnet, dass** bei Auswertung des Kollektor-Emitter-Spannungs-Verlaufes die Spannungsänderung maßgebend ist.

12. Vorrichtung nach einem der Ansprüche 8 bis 11, **dadurch gekennzeichnet, dass** der erste Zweig (1) eine Ein/Aus-Funktion mit minimalem Innenwiderstand realisiert und der zweite Zweig ( 1 ) eine konstante Ladungsträgerabfuhr gewährleistet.

13. Vorrichtung nach einem der Ansprüche 8 bis 12, **dadurch gekennzeichnet, dass** der erste Zweig (1) ein als Schalter ausgelegter Transistor und der zweite Zweig (1) ein als Konstantstromquelle beschalteter Transistor ist.

14. Vorrichtung nach einem der Ansprüche 8 bis 13, **dadurch gekennzeichnet, dass** die Zeitdauer während einer der Zweige (1) aktiviert bzw. deaktiviert ist mittels einer Zeitsteuerung definiert ist.

15. Vorrichtung nach einem der Ansprüche 8 bis 14, **dadurch gekennzeichnet, dass** die Beeinflussung der Zeitdauer über die Zeitkonstante eines RC-Gliedes erfolgt.
